Europäisches Patentamt

European Patent Office

Office européen des brevets

(11) Veröffentlichungsnummer: **0 346 606**

**A2**

(12) **EUROPÄISCHE PATENTANMELDUNG**

(21) Anmeldenummer: **89107986.5**

(22) Anmeldetag: **03.05.89**

(51) Int. Cl.⁴: **H03M 1/70**

(30) Priorität: **14.06.88 DE 3820143**

(43) Veröffentlichungstag der Anmeldung:
**20.12.89 Patentblatt 89/51**

(84) Benannte Vertragsstaaten:
**AT CH LI NL**

(71) Anmelder: **ANT Nachrichtentechnik GmbH**
**Gerberstrasse 33**
**D-7150 Backnang(DE)**

(72) Erfinder: **Göckler, Heinz, Dipl.-Ing.**
**Elbinger Strasse 52**
**D-7150 Backnang(DE)**
Erfinder: **Baudisch, Werner, Dipl.-Ing.**
**Am Söhlberg 3**
**D-3341 Denkte 1(DE)**
Erfinder: **Masslich, Roland, Dipl.-Ing.**
**Heinrichstrasse 37**
**D-3300 Braunschweig(DE)**
Erfinder: **Wermuth, Jürgen, Ing. grad.**
**Drosselweg 1**
**D-3150 Peine(DE)**
Erfinder: **Langner, Werner, Ing. grad.**
**Ringstrasse 16**
**D-3341 Klein Denkte(DE)**
Erfinder: **Hauk, Waldemar, Dr. Ing.**
**Häfnersweg 104**
**D-7150 Backnang(DE)**
Erfinder: **Gödecke, Friedrich-Wilhelm,**
**Dipl.-Ing.**
**Jasperallee 37**
**D-3300 Braunschweig(DE)**

(54) **Hochauflösender Digital/Analog-Umsetzer.**

(57) Die Erfindung betrifft einen hochauflösenden D/A-Umsetzer, unter Verwendung eines Verstärkers mit in L + 1-Stufen programmierter Verstärkung und mit Auswahl einer entsprechenden Verstärkungsstufe.

Aufgabe ist es, eine höhere Auflösung zu erreichen, als diejenige, die an sich aufgrund der Bitanzahl vorgegeben ist. Das Ziel wird erreicht, indem das digitale Eingangssignal mit einem Verstärkungsfaktor $S_i$ multipliziert wird derart, daß die Wortlänge des umzusetzenden Signals unter Vermeidung eines Überlaufs verkleinert wird. Anschließend erfolgt eine Digital/Analog-Umsetzung. Das umgesetzte Analog-Signal wird dann mit der Verstärkung $1/S_i$, welche gleich dem Kehrwert des eingangsseitigen Multiplikationsfaktors $S_i$ ist, verkleinert.

Anwendungsgebiet ist die Audiosignalverarbeitung in Tonstudios.

FIG. 1

## Hochauflösender Digital/Analog-Umsetzer

Die Erfindung betrifft ein hochauflösendes Digital/Analog-Umsetzungsverfahren gemäß Oberbegriff Anspruch 1 bzw. einen Digital/Analog-Umsetzer gemäß Oberbegriff des Anspruches 3 bzw. 6. Bei der digitalen Verarbeitung beispielsweise von Audiosignalen werden große Signalwortlängen z. B. 24 oder gar 32 Bit, verwendet, um einen hohen Signal-Geräuschabstand zu erhalten. In vielen Fällen werden solche Anlagen von analogen Signalen gespeist, die vor der digitalen Bearbeitung oder Abspeicherung von der analogen (zeitkontinuierlichen) Darstellung in die zeitdiskrete bzw. digitale Darstellung umgesetzt werden müssen, wobei nach der digitalen Bearbeitung wieder eine Rückumsetzung zu erfolgen hat. Bei den hier zu verwendenden Abtastfrequenzen im Bereich von etwa 50 KHz stehen heute preisgünstige Festkomma-A/D-Umsetzer in integrierter Form mit einer Auflösung von 16 Bit zur Verfügung, beispielsweise die Konverter vom Typ Hibit der Firma Yamaha. Darüberhinaus sind auch einzelne sehr teure Exemplare mit bis zu 18 Bit verfügbar.

Der vorliegenden Erfindung lag die Aufgabe zugrunde, einen hochauflösenden D/A-Umsetzer anzugeben, der ohne großen Mehraufwand eine noch höhere Auflösung bietet als diejenige, die an sich aufgrund der Bitanzahl gegeben ist.

Die Aufgabe wurde gelöst entsprechend den kennzeichnenden Merkmalen des Anspruches 1, 3 bzw. 6.

Der vorliegende erfindungsgemäße D/A-Umsetzer weist eine höhere Auflösung auf, als man sie bei einer bestimmten Wortlänge erhalten würde, er weist nämlich eine Auflösung auf, die einer um m Bit größeren Wortlänge entspricht. Der Aufwand hierfür ist relativ niedrig. Die Erfindung geht aus von der Idee, daß ein D/A-Umsetzer bei Vollaussteuerung eine geringere Auflösung als bei abnehmender Aussteuerung aufweisen kann, d. h. daß die Auflösung bei kleinsten Aussteuerungspegeln am höchsten ist beispielsweise 20 Bit und mit zunehmenden Pegeln kleiner werden kann. Diese Eigenschaft rührt daher, daß auch noch leise Passagen, beispielsweise eines Musikstücks, mit einem hohen Signalgeräuschabstand in die digitale Darstellung zu überführen sind. Dagegen genügt bei lauten Passagen, also Signalen mit großen Amplituden eine Auflösung, d. h. Genauigkeit der Darstellung von beispielsweise 16 Bit.

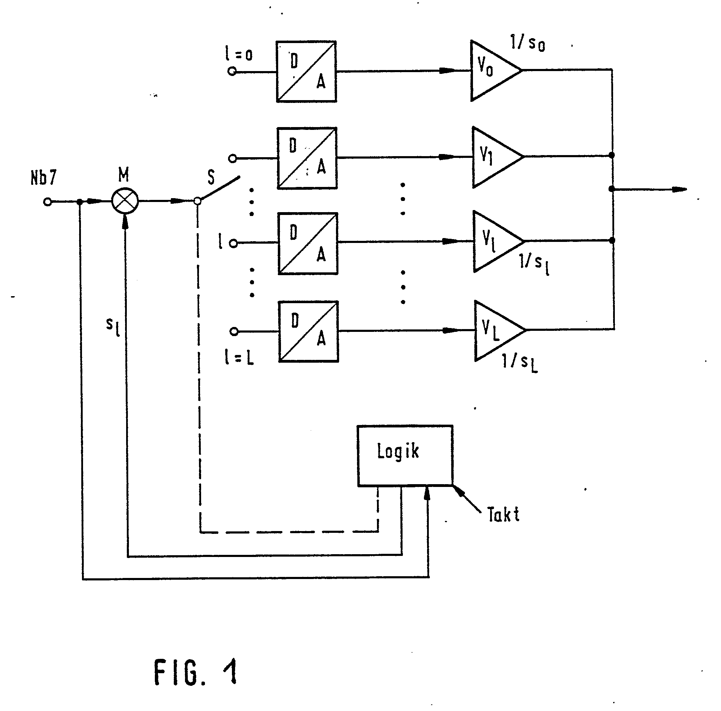

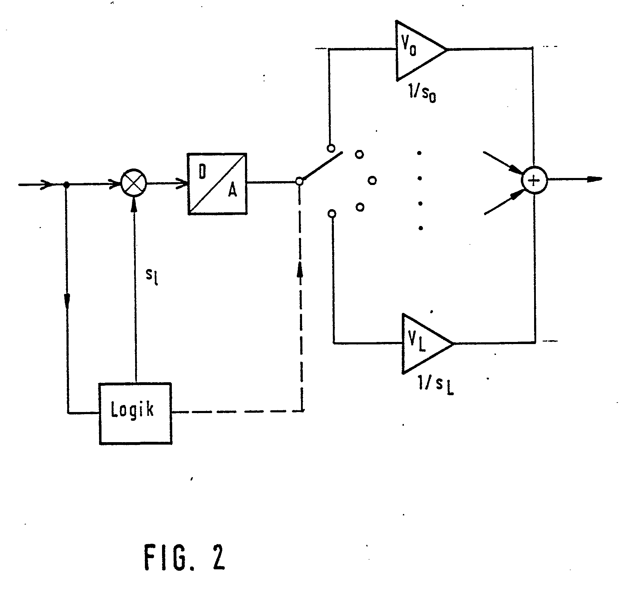

Es folgt nun die Beschreibung der Erfindung anhand der Figuren. Die Grundstruktur der erfindungsgemäßen Lösung für einen hochauflösenden D/A-Umsetzer ist in Figur 1 wiedergegeben. Eine Ausgestaltung ist der Figur 2 zu entnehmen.

In Figur 1 sind L + 1 parallele im wesentlichen gleiche Zweige vorgesehen, bestehend aus der Kaskadenschaltung jeweils eines Verstärkers $V_l$ für l = 0 bis L und eines vorgeschalteten D/A-Umsetzers mit der Auflösung (N-m) Bit, wobei alle L + 1 D/A-Umsetzer identisch sein können. Die Verstärker, die ausgangsseitig parallelgeschaltet, weisen jeweils eine zweigabhängige Verstärkung (Skalierung) $1/S_l$ auf. Jeweils ein D/A-Umsetzereingang kann mittels eines Auswahlschalters S, eine digitale Torschaltung, auf den Ausgang eines digitalen Multiplizierers geschaltet werden, der den jeweiligen digitalisierten Eingangs-Abtastwert mit dem Kehrwert $S_l$ der Verstärkung des Verstärkers $V_l$ des gerade durchgeschalteten Zweigs l multipliziert. Dieser Skalierungsfaktor weist zwar eine Wortlänge m auf aber gleichzeitig einen solchen Wert, so daß das Multipliziererausgangssignal nunmehr auf die um m verkleinerte Wortlänge N-m Bit reduziert werden kann. Die Stellung des Auswahlschalters S wird durch eine digitale Logikschaltung festgelegt, ebenso der jeweilige zugehörige Rückskalierungsfaktor $1/S_l$. Die Logikschaltung wird gespeist durch die Eingangsgröße des digitalen Mutliplizierers. Dabei wird der Skalierungsfaktor $S_l$ so festgelegt, daß der jeweilige D/A-Umsetzer weitestmöglich ausgesteuert, aber nicht übersteuert wird. Grundregel ist, daß die Logikschaltung von all den Zweigen mit nichtübersteuerten Verstärkern $V_l$ stets denjenigen durchschaltet, bei dem der Ausgangssignalwert die geringste Übersteuerungsreserve aufweist, d. h. denjenigen Verstärker, der gerade am weitesten ausgesteuert ist, ohne übersteuert zu sein. Vorteilhafterweise läßt sich die Übersteuerung durch Überprüfung des eingangsseitigen Digitalwortes in der Logik überwachen, durch welche dann dem Multiplizierer M der entsprechende Wert $S_l$ angeboten und der Auswahlschalter S entsprechend angesteuert wird. Ergänzend sei bemerkt, daß sich die Stellung des Schalters S im Takt $T = 1/f_A$ mit der Abtastfrequenz $f_A$ ändern kann, weshalb die Logikschaltung ebenfalls mit dem Takt T ebenso wie die D/A-Umsetzer getaktet wird.

Die Erhöhung der Auflösung bei Aussteuerungen ≤ $S_0/S_L$ beträgt

m = ld $S_L/S_0$ Bit

mit ld = Logarithmus dualis.

Ist beispielsweise L = 3, so ergeben sich die einzelnen Skalierungen zu $S_0$ = 1, $S_1$ = 3/2, $S_2$ = 9/4 und $S_3$ = 27/8. Mit $S_0/S_L$ = 8/27 wird m = ld 27/8 ungefähr gleich 1,75 Bit. Staffelt man die Skalierungen nach folgender Gleichung

$S_l = 2^i \cdot 2^l$ mit i = konstant,

so wird die Erhöhung der Auflösung m = L, weil m = $ld\, s_L/S_0$ = $ld\, 2^L$ = L. $S_0/S_L$ wird damit zu $2^{-L}$. Die Auflösung der D/A-Umsetzeranordnung gemäß Figur 1 erhöht sich dann genau um 1 Bit, wenn der Ausgangswert auf die Hälfte abgesunken ist. Weiterhin vereinfacht sich die Skalierung im digitalen Multiplizierer mit $1/S_l = 2^{-i} \cdot 2^{-l}$ zu einer reinen Schiebeoperation, die dann aufgrund der Wortbreite von mindestens N Bit keinen zusätzlichen Quantisierungsfehler verursacht.

Besonders vorteilhaft ist die D/A-Umsetzer-Anordnung gemäß Figur 2, die einen solchen D/A-Umsetzer zeigt. Diese Anordnung geht aus der Anordnung gemäß Figur 1 hervor, indem lauter identische D/A-Umsetzer gewählt werden, wobei dann diese D/A-Umsetzer vor den Auswahlschalter S gezogen und ersetzt werden können durch einen einzigen D/A-Umsetzer. Der Auswahlschalter S ist dann wieder als Analogschalter zu realisieren. Generell werden auch hier durch die Logikschaltung aus der Auswertung des digitalen Eingangssignals jeweils der erforderliche Skalierungsfaktor $S_l$ und der zugehörige Zweig abgeleitet.

## Ansprüche

1. Verfahren zur hochauflösenden Digital/Analog-Umsetzung, unter Verwendung eines Verstärkers mit in L+1-Stufen programmierter Verstärkung und mit Auswahl einer entsprechenden Verstärkungsstufe, die das ohne Übersteuerung höchstmögliche Signal nach D/A-Umsetzung liefert, dadurch gekennzeichnet,
daß das N-Bit breite digitale Eingangssignal mit einem Verstärkungsfaktor $S_l$ der Wortlänge m multipliziert wird derart, daß die Wortlänge des umzusetzenden Signals unter Vermeidung eines links- oder rechtsbündigen Überlaufs verkleinert wird,
daß anschließend eine Digital/Analog-Umsetzung erfolgt und
daß das umgesetzte Analog-Signal einem Verstärker $(V_l)$ mit der Verstärkung $1/S_l$, welche gleich dem Kehrwert des eingangsseitigen Multiplikationsfaktors $S_l$ ist und an dessen Ausgang das umgesetzte Analog-Signal zur Weiterverarbeitung ansteht, zugeführt wird.

2. Verfahren nach Anspruch 1, dadurch gekennzeichnet, daß das digitale Wort eine Festkommazahl ist.

3. Digital/Analog-Umsetzer zur Durchführung des Verfahrens nach Anspruch 1 oder 2, dadurch gekennzeichnet,
daß L+1-Verstärker $(V_0, V_1, \dots V_l, \dots V_L)$ mit den Verstärkungen $(1/S_0 > 1/S_1 > \dots > 1/S_l > \dots > 1/S_L)$ vorgesehen sind, deren Ausgänge parallel geschaltet sind,
daß den Verstärkern jeweils ein D/A-Umsetzer vorgeschaltet ist,
daß ein Multiplizierer (M) und ein Auswahlschalter (S) vorgesehen sind, durch welch letzteren das Multiplizierer-Ausgangssignal demjenigen Zweig aus kaskadiertem D/A-Umsetzer und Verstärker zugeführt wird, dessen Verstärker die Verstärkung aufweist, welche den Kehrwert des Faktors $(S_l)$ aufweist, mit dem das digitale Eingangssignal multipliziert wird, so daß am D/A-Umsetzerausgang das höchstmögliche nichtübersteuerte Analog-Signal entsteht (Figur 1).

4. Digital/Analog-Umsetzer nach Anspruch 3, dadurch gekennzeichnet,
daß eine Logik vorgesehen ist, durch welche die Umsetzer auf Übersteuerung überwacht werden, durch welche der Auswahlschalter (S) angesteuert wird und durch welche die Bereitstellung des entsprechenden Multiplikationsfaktors $(S_l)$ an den Multiplizierer (M) erfolgt.

5. Digital/Analog-Umsetzer nach Anspruch 4, dadurch gekennzeichnet,
daß zur Prüfung einer Übersteuerung der D/A-Umsetzer der Logik das digitale Eingangssignal der Gesamtanordnung zugeführt wird (Figur 1).

6. Digital/Analog-Umsetzer zur Durchführung des Verfahrens nach Anspruch 1 oder 2, dadurch gekennzeichnet,
daß L+1-Verstärker oder Widerstandteiler mit den Abschwächungsfaktoren $1/S_0 > 1/S_1 > \dots > 1/S_l > \dots > 1/S_L$ vorgesehen sind, denen über einen Auswahlschalter (S) das Ausgangssignal eines D/A-Umsetzers zuführbar ist,
daß ein Multiplizierer vorgesehen ist, durch den das digitale Eingangssignal mit einem Verstärkungsfaktor $S_l$ derart multipliziert wird,
daß sein Ausgangssignal dem nachfolgenden D/A-Umsetzer zugeführt ein Analog-Signal erzeugt, welches größtmöglich ist ohne übersteuert zu sein, und
daß durch den Auswahlschalter (S) das umgesetzte Analog-Signal demjenigen Verstärker bzw. Widerstandteiler zugeführt wird, welcher den Abschwächungsfaktor gleich dem Kehrwert des eingangsseitigen Multiplikationsfaktors $S_l$ aufweist (Figur 2).

7. Digital/Analog-Umsetzer nach Anspruch 5, dadurch gekennzeichnet,
daß durch den Auswahlschalter (S) derjenige Verstärker oder Widerstandteiler benutzt wird, dessen Verstärkung oder Abschwächungsfaktor den Kehrwert des eingangsseitig verwendeten Multiplikationsfaktors $S_l$ aufweist, und
daß bei der Benutzung den Verstärkern oder den Widerstandteilern über den Auswahlschalter das Eingangssignal getrennt zugeführt und/oder das Ausgangssignal getrennt abgeführt wird.

8. Digital/Analog-Umsetzer nach einem der Ansprüche 3 bis 7, dadurch gekennzeichnet, daß die Multiplikationsfaktoren zu $S_l = 2^i \cdot 2^l$ gewählt werden mit i = konstant und l = 0 ... bis L.

FIG. 1

FIG. 2